Europäisches Patentamt

(19) European Patent Office

Office européen des brevets

(11) Numéro de publication: **0 009 435
B1**

(12) **FASCICULE DE BREVET EUROPEEN**

(45) Date de publication du fascicule du brevet:
20.07.83

(21) Numéro de dépôt: 79400622.1

(22) Date de dépôt: 06.09.79

(51) Int. Cl.³: **H 03 B  9/14,** H 01 P  1/26 //
**G01S7/02**

(54) **Dispositif oscillateur stabilisé pour hyperfréquence à l'état solide.**

(30) Priorité: **15.09.78 FR 7826553**

(43) Date de publication de la demande:
**02.04.80 Bulletin 80/7**

(45) Mention de la délivrance du brevet:
**20.07.83 Bulletin 83/29**

(84) Etats contractants désignés:
**BE DE GB NL SE**

(56) Documents cités:
**US-A-3 868 594**
**US-A-4 034 314**

**ELECTRONIC ENGINEERING, vol. 46, no. 561, novembre 1974, London (GB) «MIC band filters using open-ring resonators» page 29**

**1974 INTERNATIONAL SOLID STATE CIRCUITS CONFERENCE, 15 février '74, New York (US) SATOH «Stabilized microstrip oscillator using a temperature stable dielectric resonator», pages 184–185**

(73) Titulaire: **THOMSON-CSF, 173, Boulevard Haussmann, F-75379 Paris Cedex 08 (FR)**

(72) Inventeur: **Bert, Alain, "Thomson-CSF" - SCPI 173, bld Haussmann, F-75360 Paris Cedex 08 (FR)**
Inventeur: **Le Clerc, Bernard, "Thomson-CSF" - SCPI 173, bld Haussmann, F-75360 Paris Cedex 08 (FR)**

(74) Mandataire: **Benichou, Robert et al, THOMSON-CSF SCPI 173 bld Haussmann, F-75379 Paris Cedex 08 (FR)**

Dispositif oscillateur stabilisé pour hyperfréquence à l'état solide

L'invention concerne un oscillateur radioélectrique à l'état solide pour le domaine des hyperfréquences. Elle concerne plus exactement le dispositif d'ensemble constitué par l'oscillateur proprement dit et les moyens qui lui sont associés pour éliminer les oscillations parasites qui pourraient prendre naissance sur des fréquences autres que celle désirée, harmoniques en particulier. L'oscillateur proprement dit comporte un dipole actif à résistance négative qui peut être par exemple réalisé par une diode Gunn ou avalanche.

On connaît de tels ensembles (voir notamment Magalhaes and Kurokawa Proc. IEEE 1970.58–831–832) dans lesquels cette élimination, c'est-à-dire la stabilisation de l'ensemble sur la fréquence de fonctionnement désirée, est réalisée au moyen d'une charge d'amortissement, distincte ou non de la charge d'utilisation. Cependant, dans la plupart des ensembles connus en question, cette charge d'amortissement absorbe une partie de la puissance engendrée lorsqu'on se trouve sur la fréquence de fonctionnement désirée, réduisant ainsi, toutes choses égales par ailleurs, la puissance de sortie du dispositif et détériorant ses caractéristiques de bruit.

La solution apportée à cette situation consiste, suivant l'art antérieur (brevet US-A-4 034 314), à introduire un filtre stop-bande centré autour de la fréquence d'oscillation entre le résonateur de l'oscillateur et la charge d'amortissement, une extrémité de cette dernière étant reliée à la masse.

Mais l'oscillateur décrit dans le brevet US-A-4 034 314 est réalisé dans une technologie «à trois dimensions» et comporte des cavités et lignes coaxiales usinées dans un bloc de métal. Selon cette technologie, il est aisé de relier la charge d'amortissement à la masse électrique.

L'oscillateur stabilisé selon la présente invention est réalisé en technologie microbandes, c'est-à-dire que tous les composants à l'état solide – diode, résonateur, lignes de transmissions, charges – sont disposés sur une face d'un substrat plan, dont l'autre face, métallisée, constitue le plan de masse. Il est alors intéressant de placer la charge d'amortissement en amont du filtre stop-bande: ceci évite de réunir la charge d'amortissement à la masse, sur la face opposée métallisée du substrat, par une bande de métallisation dont un premier inconvénient est la métallisation de la tranche du substrat et un second inconvénient est l'inductance créée, aux fréquences de travail de ce genre d'oscillateur, c'est-à-dire dans les gigahertz.

Placer la charge d'amortissement avant le filtre stop-bande évite cette inductance parasite sur la mise à la masse. Elle est reliée à un dipole réactif constitué par le filtre stop-bande et une impédance micro-bande de longueur $\lambda/4$ ($\lambda$ étant la longueur d'onde à la fréquence $f_o$) qui, elle non plus, n'est pas reliée à la masse.

Le dipole réactif ramène en série avec ladite charge d'amortissement une impédance faible dans toute la gamme de fréquence où l'élément actif présente une résistance négative, et une impédance très élevée, par rapport à la valeur de la charge d'amortissement, dans une bande étroite de fréquences autour de la fréquence d'oscillation. Un tel dipole réactif peut être réalisé très simplement grâce à des portions de lignes de propagation, dont aucune partie n'est reliée à la masse: par exemple une ligne microbande demi-onde à la fréquence $f_o$. On assure ainsi le découplage de la polarisation de l'élément actif, aucun courant issu de l'alimentation ne pouvant se refermer dans la charge d'amortissement, et cela sans introduction de capacité de découplage supplémentaire, ni utilisation de charge sélective en fréquence comme c'est le cas dans le document US-A-3 868 594, ou dans Kurokawa.

L'invention sera mieux comprise en se reportant au texte qui suit et aux figures jointes qui représentent:

la fig. 1, le schéma général d'un oscillateur à diode stabilisé en fréquence d'après l'art connu,

les figs 2 et 3, des diagrammes explicatifs concernant l'oscillateur de la fig. 1,

les figs 4 et 5, les schémas électriques équivalents d'un oscillateur à diode stabilisé selon l'art antérieur et selon l'invention respectivement,

la fig. 6, une forme de réalisation d'un oscillateur à diode stabilisé de l'invention.

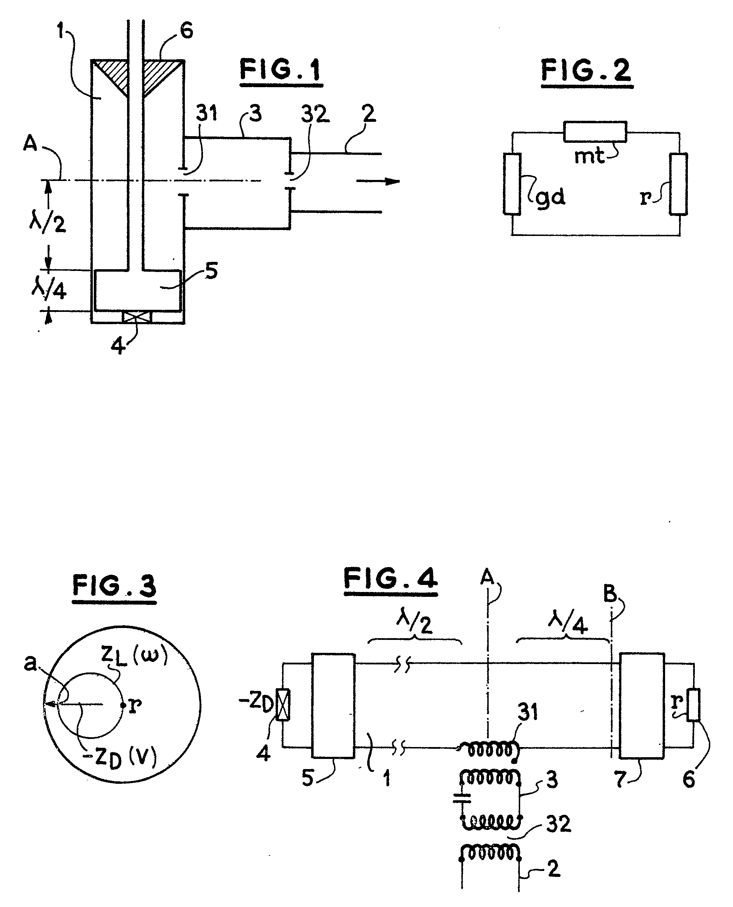

Afin de faciliter la compréhension de l'invention, on décrit ci-dessous, à l'aide des figs 1, 2, 3 et 4, les dispositifs oscillateurs stabilisés à diode, pour hyperfréquences, parmi les plus connus de l'art antérieur.

Une cavité à forte surtension 3, réglable en fréquence, résonnant à la fréquence $f_o$, est couplée par des iris, portant les repères 31 et 32, à une première ligne de transmission de structure coaxiale 1 et à une seconde ligne de transmission, 2, terminée sur une charge d'utilisation, non représentée, située en dehors des limites de la figure vers la droite (flèche); à ces iris correspondent les coefficients de couplage $m_1$ et $m_2$ respectivement. Dans la structure coaxiale se trouve l'oscillateur à l'état solide proprement dit 4, comme déjà dit, une diode à résistance négative, à laquelle sont associées, bien qu'ils ne soient pas représentés, comme appartenant à l'art, les moyens nécessaires pour provoquer au sein de celle-ci la naissance d'oscillations à fréquences radio-électriques. En 5 est représenté un transformateur d'impédance à $\dfrac{\lambda}{4}$ (la lettre $\lambda$ désigne la longueur d'onde correspondant à la fréquence de fonctionnement désirée $f_o$ du système), selon la pratique bien connue en hyperfréquence. On voit sur la figure que, dans l'exemple, l'iris 31 se trouve à $\dfrac{\lambda}{2}$ de la sortie du transformateur 5. Le

repère 6 désigne la charge d'amortissement qui termine la ligne coaxiale 1.

La stabilisation de fréquence résulte dans un tel système de ce qui suit. Hors résonance, l'impédance dans la ligne coaxiale au niveau de l'entrée du transformateur 5, c'est-à-dire au niveau du trait supérieur du rectangle 5, est égale à r, r désignant l'impédance de la charge 6 choisie égale à l'impédance caractéristique de la ligne coaxiale, et à l'unité si l'on considère, comme ce sera le cas dans ce qui suit, les impédances réduites, mesurées en prenant l'impédance caractéristique de la ligne coaxiale 1 comme unité; ainsi chargée, après transformation par l'élément 5, la diode 4 n'oscille pas. A la fréquence de résonance $f_o$, au contraire, à cette impédance s'ajoute celle transmise par la cavité 3 chargée par la charge d'utilisation et couplée à la ligne 1 par les iris successifs 31 et 32. Cette nouvelle impédance a pour expression, en valeur réduite, une quantité de forme $m_t = \dfrac{m_1}{1 + m2}$, et le circuit équivalent à la fréquence $f_o$ se présenterait comme l'indique la fig. 2, montrant en série les charges $m_t$ et r au niveau de l'entrée du transformateur 5; $g_d$ représente l'impédance de la diode 4 à ce niveau.

La fig. 3 est la représentation sur un diagramme de Smith de l'impédance de charge totale du circuit $Z_L$ ($\omega$) ($\omega = 2\pi f$, (qui dépend de la fréquence de fonctionnement f par la partie résultant de la présence de la cavité 3) au niveau de l'élément actif 4 d'impédance $Z_D$ (V), V étant la tension haute fréquence au niveau de la diode. L'oscillation se produit pour $Z_L = -Z_D$ (point a du diagramme). Ceci étant, on notera qu'à la fréquence $f_o$, l'énergie d'oscillation fournie par la diode se répartit entre la cavité et la charge d'utilisation, d'une part, et la charge d'amortissement, d'autre part, dans le rapport $\dfrac{m_t}{r}$. L'énergie dissipée dans la charge d'amortissement 6 est alors perdue. Pour réduire cette perte, on a proposé de réduire au maximum la valeur de r, à l'aide, par exemple, d'un transformateur d'impédance (voir R. Knöckel, K. Schünemann; Electronics Letters 1977, 13 N° 19, 583).

Selon l'invention, on réduit cette perte à une valeur pratiquement nulle en adjoignant un filtre sélectif en fréquence à la charge d'amortissement 6, dans les conditions qui vont être précisées. Ce filtre est contré sur la fréquence $f_o$. Mais, alors que dans l'art antérieur (voir le document US-A-4 034 314) ce filtre est disposé en parallèle avec la charge d'amortissement 6 à l'extrémité de la ligne de transmission 1, dans l'invention il est monté en série avec cette charge.

Selon cet art antérieur, un filtre stop-bande est intercalé entre l'iris 31 de couplage de la cavité 3 à la ligne coaxiale 1 et la charge d'amortissement 6. Le circuit équivalent de l'ensemble du dispositif serait alors celui de la fig. 4, dans laquelle les mêmes repères désignent les mêmes éléments que sur la fig. 1. Sur la figure, 7 désigne le filtre stop-bande du dispositif. A désigne le plan médian de l'iris de couplage de la cavité 3; la cavité 3 est représentée par le circuit résonnant qui lui est équivalent, couplé à la ligne 2 par action mutuelle. Dans l'exemple de la fig. 4, le plan B est séparé de l'iris A par un tronçon de ligne de longueur $\dfrac{\lambda}{4}$ (ou multiple impair de $\dfrac{\lambda}{4}$), $\lambda$ désignant la longueur d'onde correspondant à la fréquence $f_o$); à la résonance, c'est-à-dire à la fréquence $f_o$, du fait de la présence du filtre 7, l'impédance de la ligne 1 est infinie dans le plan B et nulle au niveau A de l'iris de couplage. A l'entrée du transformateur 5, séparée du plan A par une longueur de ligne $\dfrac{\lambda}{2}$ (ou multiple de $\dfrac{\lambda}{2}$), l'impédance totale de charge se réduit alors à la quantité $m_t$ du schéma de la fig. 2 et, à la résonance, la perte dans la charge d'amortissement r est pratiquement annulée. Toute la puissance engendrée est alors absorbée par la charge fermant la ligne 2.

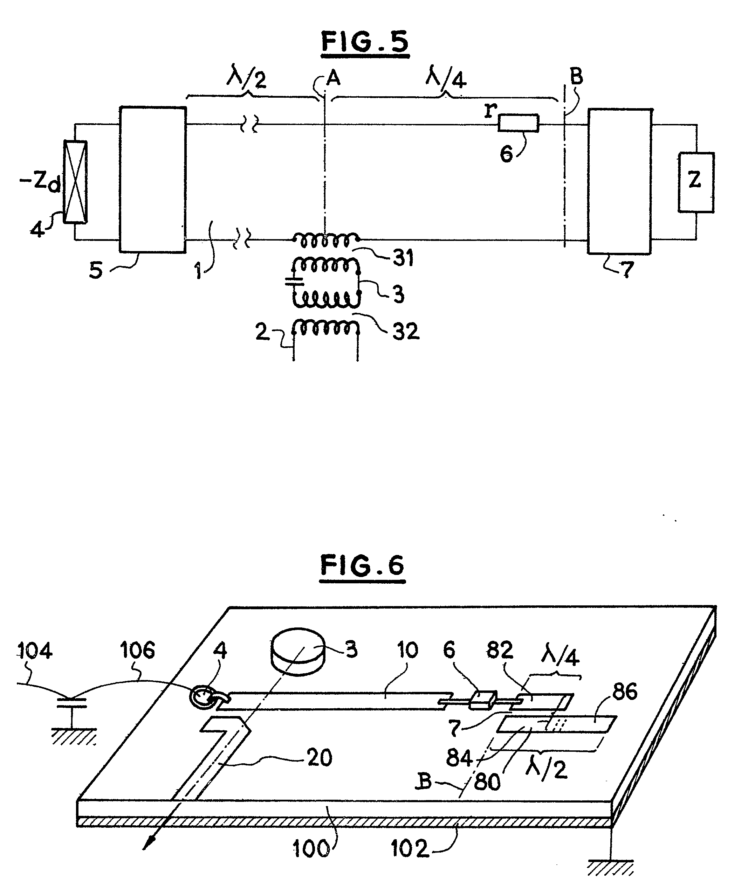

Contrairement à cet art antérieur, dans le dispositif de l'invention le filtre 7 est disposé en série avec la charge d'amortissement et l'iris 31; il est fermé sur une impédance Z, réactive, comme le montre la fig. 5. A la résonance $f_o$, la ligne se comporte comme un circuit ouvert dans le plan B et fermé sur une impédance nulle dans le plan A, séparé du plan B par un tronçon de $\dfrac{\lambda}{4}$ de longueur. La conclusion est la même que dans le cas précédent.

Dans les exemples des figs 4 et 5, le plan B est un plan d'impédance infinie de la ligne 1 à la sortie du filtre 7. Dans le cas où cette sortie correspondrait à un plan d'impédance nulle, il va sans dire que, suivant la pratique connue, la distance AB devrait être égale à un multiple de $\dfrac{\lambda}{2}$.

La fig. 6 montre une forme de réalisation du dispositif de l'invention dans la technologie «micro-bandes», utilisant, comme éléments constitutifs des circuits hyperfréquence, des conducteurs déposés sur un substrat isolant, constitué de silice ou d'alumine par exemple, recouvert sur l'une de ses faces d'une couche conductrice de l'électricité.

Le substrat en question porte le repère 100 et la couche conductrice le recouvrant sur l'une de ses faces le repère 102.

La cavité 3 est en outre, dans cette réalisation, un résonateur diélectrique. Sur la figure, les mêmes repères désignent les mêmes éléments que sur les figures précédentes.

La technologie utilisée est de pratique courante en matière d'hyperfréquences; on précisera donc quelques points particuliers seulement.

La diode 4 est alimentée dans les conditions connues de l'art par une source non représentée, à travers le conducteur 104 et la capacité de découplage 106.

Une bande de réjection de 2% est facilement réalisable avec un tel filtre. La charge d'amortissement est réalisée par dépôt métallique sur le substrat 100; elle peut aussi dans certaines autres réalisations de l'invention être de type hybride. La cavité résonnante 3 est un résonateur diélectrique connu également de la technique; il consiste en un cylindre plein en l'un des matériaux utilisés ordinairement, à savoir un mélange d'oxydes de corps tels que le titane et l'étain. Il est posé sur le substrat 100 et placé en réflexion par rapport à la ligne 10, son plan médian (trait mixte) à environ $\frac{\lambda}{4}$ de l'extrémité de celle-ci. Il pourrait également, dans les limites de l'invention, être placé en transmission, entre le conducteur 10 et le conducteur 20.

La charge 6 est reliée au filtre 7 constitué d'un tronçon 80 de deux lignes couplées 82 et 84 de longueur $\frac{\lambda}{4}$, dont l'une est reliée à la charge 6 par l'une de ses extrémités et ouverte à l'autre, et dont l'autre est ouverte à l'une de ses extrémités et fermée sur un tronçon de ligne 86 de $\frac{\lambda}{4}$ de longueur, comme le montre le dessin.

On a obtenu avec une structure telle que celle décrite sur la fig. 6 des puissances de quelques watts, à 10 gigahertz, sans dissipation appréciable de puissance dans la charge d'amortissement à la résonance du système.

Les dispositifs de l'invention ont les mêmes applications que ceux de l'art connu, comme oscillateurs locaux dans les radars notamment.

**Revendications**

1. Dispositif oscillateur pour hyperfréquences, à l'état solide, comportant une diode (4) à résistance associée à des moyens pour la faire osciller, des moyens de couplage entre la diode et une ligne de transmission (10) comportant, à une extrémité, une charge utile (20) et, à l'autre extrémité, une charge d'amortissement (6), la ligne de transmission (10) étant couplée à un résonateur (3) à la fréquence $f_o$ de fonctionnement, et la charge d'amortissement (6) étant placée en série avec un filtre coupe-bande (7) à ladite fréquence $f_o$, cet oscillateur étant caractérisé en ce qu'il est réalisé en technologie microbandes et en ce que la charge d'amortissement (6) est située en amont du filtre (7) coupe-bande.

2. Dispositif oscillateur pour hyperfréquences selon la revendication 1, caractérisé en ce que le filtre coupe-bande (7) est constitué par des lignes (82, 84, 86) réalisées en technologie microbandes, sur un substrat plan (100), électriquement isolant, recouvert sur l'une de ses faces d'une couche conductrice (102) de l'électricité faisant plan de masse, ce filtre coupe-bande (7) étant formé par deux tronçons (82, 84) de lignes microbandes parallèles, de longueur λ/4 (λ désignant la longueur d'onde à la fréquence $f_o$), dont l'un (82), situé dans le prolongement de la ligne de transmission (10), est relié par sa première extrémité à la charge d'amortissement (6) et ouvert à sa seconde extrémité, et dont l'autre (84) est relié à un tronçon de ligne (86) ouverte, de longueur λ/4.

**Claims**

1. Solid state UHF-oscillator device comprising a resistor diode (4) which is associated to means which make it oscillate, and coupling means between the diode and a transmission line (10) which comprises at one end a useful load (20) and at the other end a damp load (6), the transmission line (10) being coupled to a resonator (3) at the operating frequency $f_o$, and the damp load (6) being placed in series with a band cut filter (7) cutting at said frequency $f_o$, characterized in that the oscillator is made up according to the microstrip technology and that the damp load (6) is situated upstream of the band cut filter (7).

2. UHF-oscillator device according to claim 1, characterized in that the band cut filter (7) is constituted by lines (82, 84, 86) realized according to the microstrip technology on a plane substrate (100) which is electrically insulating and one face of which is covered by an electrically conductive layer (102) constituting the earth plane, the band cut filter (7) being made of two portions (82, 84) of parallel microstrip lines of λ/4 length (λ designing the wave length at the frequency $f_o$), one of these portions (82) which is situated in the prolongation of the transmission line (10) being connected by its first end to the damp load (6) and being open at its second end, whereas the other line portion (84) is connected to an open line portion (86) of λ/4 length.

**Patentansprüche**

1. UHF-Oszillatorvorrichtung auf Festkörperbasis, mit einer Widerstandsdiode (4), die Mitteln zugeordnet ist, durch die sie in Schwingung gerät, und mit Koppelmitteln zwischen der Diode und einer Übertragungsleitung (10), die an einem Ende eine Nutzlast (20) und am anderen Ende eine Dämpfungslast (6) besitzt und an einen Resonator (3) bei der Betriebsfrequenz $f_o$ gekoppelt ist, wobei die Dämpfungslast (6) in Reihe mit einem Bandsperrfilter (7) der Sperrfrequenz $f_o$ angeordnet ist, dadurch gekennzeichnet, dass der Oszillator gemäss der Mikrostriptechnik hergestellt ist und dass die Dämpfungslast (6) vor dem Bandsperrfilter (7) angeordnet ist.

2. UHF-Oszillatorvorrichtung nach Anspruch 1, dadurch gekennzeichnet, dass das Bandsperrfilter (7) aus nach der Mikrostriptechnologie hergestellten Linien (82, 84, 86) besteht, die auf einem ebenen, elektrisch isolierenden und einseitig mit einer elektrisch leitenden, als Masseebene wirkenden Schicht (102) versehenen Substrat (100) aufgebracht sind, wobei das Bandsperrfilter (7) aus zwei Abschnitten von parallelen Mikrostriplinien der Frequenz λ/4 besteht (λ bezeichnet die Wellenlänge bei der Frequenz $f_o$), von denen ein Abschnitt (82), der in der Verlängerung der Übertragungsleitung (10) liegt, mit einem ersten Ende an die Dämpfungslast (6) angeschlossen und mit einem anderen Ende offen ist, während der andere Abschnitt (84) an einen offenen Linienabschnitt (86) der Länge λ/4 angeschlossen ist.

FIG.1

FIG.2

FIG.3

FIG.4

## FIG.5

## FIG.6